# EUROPEAN PATENT SPECIFICATION

(11) **EP 0 388 217 B1**
(45) Date of publication and mention of the grant of the patent: **26.07.1995**
(21) Application number: 90302828.0
(22) Date of filing: 15.03.1990
(51) Int. Cl.: G12B 17/00, H05K 9/00, G01R 1/18

(54) **Circuit protection apparatus**
Schaltungsschutzvorrichtung
Appareil pour protéger des circuits

(30) Priority: 17.03.1989 GB 8906146
(43) Date of publication of application: 19.09.1990
(73) Proprietor: Hamilton, Sheila, Greenock PA16 8DN, Scotland (GB)
(72) Inventor: Hamilton, Sheila, Greenock PA16 8DN, Scotland (GB)
(74) Representative: Pacitti, Pierpaolo A.M.E.

(56) References cited:
- DE-A- 3 631 531
- DE-A- 3 715 715
- POLYMER-PLASTICS TECHNOLOGY AND ENGINEERING, 17(1), 1-10(1981) SIMON, EMI shielding through conductive plastics, pages 1-10

## Description

The present invention relates to circuit protection device particularly, but not exclusively for use with printed circuit boards (PCB's) and the like.

Electronic components such as integrated circuit 'chips' and printed circuit boards incorporating such components are very sensitive to low levels of electricity such as static voltages and are also sensitive to heat generated by the components when in use. Small voltages such as created by static electricity can destroy the sensitive transistors and like components within integrated circuits rendering them useless. In addition, if the components are not properly cooled then they operate inefficiently and a build-up of heat can destroy the integrity of the component.

One way of protecting integrated circuits such as chips in transit is to use a conductive polymer bag to prevent a build-up of static. These bags are used for protecting the chip during transport only and it is difficult to ground the bags to dissipate build-up of static charge. With this arrangement there is no thermal management control and the bags are not intended to cover the components when in use.

Electronic equipment is currently shielded only at the enclosure level but this shielding is not fully effective because the enclosure often has slots for ventilation which allows electromagnetic radiation to pass through and cause interference. Also the joints in the enclosures are difficult to shield completely and grounding between various pieces of the enclosure is also difficult. Therefore, existing printed circuit board assemblies are subject to interference from electromagnetic radiation. In addition there is a minimal thermal management of the components in the printed circuit board.

There is known from DE-A-3 715 715 a combination of a plurality of layers which forms a laminate for use in a circuit protection device. However, such a laminate would not be used both for transit and use of the circuit. Again, DE-A-3 631 531 shows a polyester sheet having thermal characteristics but no indication is given as to how this could effectively be used in a circuit protection device.

It is also known from Polymer-plastic Technology and Engineering, 17(1), 1-10(1981), R Simon "EMI shielding through conductive plastics" page 4 to use polymers for electromagnetic radiation shielding but the systems disclosed here would not be adequately suitable in the protection device.

An object of the present invention is to provide a circuit protection device to provide electrical protection to circuits or sensitive components during transport and in use and also to provide thermal management of the circuitry when in use.

This is achieved by providing a multi-layer laminate having a first outer layer of an electrically insulating material bonded to a second middle layer of electrically conductive material which in turn is bonded to an inner third layer of an electrically insulating material. The second layer has a high thermal conductivity and said layers are arranged to form a deformable laminate. The electrically conductive layer or core provides electromagnetic interference (EMI) shielding and can be coupled to a ground earth supply in the equipment in which the circuit is being used.

The inner third layer of the electrical insulating polymer prevents shorting between the electrical conductors and components on the board and the conductive core. The laminate is formed into a bag which receives the PCB and which is then evacuated and sealed to cover the PCB closely to provide physical and electrical protection as well as facilitating thermal management of the enclosed circuitry.

In one arrangement the laminate is supplied in sheet form and a single piece of laminate is folded to provide a bag or container for each printed circuit board to provide effective shielding.

According to one aspect of the present invention there is provided a circuit protection device comprising a first, electrically insulating, layer; a second, electrically conductive, layer; and a third, electrically insulating, layer.

Preferably, a thermal absorption layer is provided between the second and the third layer in order to absorb heat transferred through the third layer.

Preferably said first, said second, and said third layers are polymers.

Preferably also said third electrically insulating layer has a hydrophillic coating on its inner surface. Additionally, an anti-static coating may be provided on the inner surface of the third electrically insulating layer.

Preferably the electrically conductive layer consists of a multi-layered core for providing specific properties for shielding said circuitry against particular frequencies of electromagnetic radiation.

Preferably a layer of thermographic crystals is disposed on the surface of the second electrically conductive layer adjacent the first insulating layer for providing a visual indication of temperature during the operation of the circuitry.

Preferably also a low friction coating is provided on the inner surface of the first layer.

Conveniently an identification layer for security purposes is incorporated within the laminate.

Conveniently the laminate is formed into a bag made from a single sheet to ensure that an equipotential exists over the bag and all joins on the bag are overlapped.

Preferably the joins are sealed using an insulating or conductive adhesive or are sealed using high frequency sealing.

Preferably the bag is used by fitting over a circuit board assembly the bag and evacuating the bag so that the inner surface of the laminate contacts components on the printed circuit board.

According to a second aspect of the present invention there is provided a method of protecting an electrical component with the foregoing device, characterised in that there is included the step of shaping the laminate to be in close contact to the components of the circuit to be protected such that the apparatus protects the circuits both during transit and use of the circuit.

Embodiments of the present invention will now be described by way of example with reference to the accompanying drawings in which:-
Fig. 1 is a perspective and part sectional view of a printed circuit board disposed within an evacuated bag in accordance with an embodiment of the present invention with the printed circuit board shown disposed within card guides;
Fig. 2 is a cross-sectional view through one embodiment of a laminate made in accordance with the present invention;
Fig. 3 is a cross sectional view of a rigid circuit protection device made in accordance with the present invention; and
Fig. 4 is an exploded cross sectional view through another embodiment of a laminate made in accordance with the present invention.

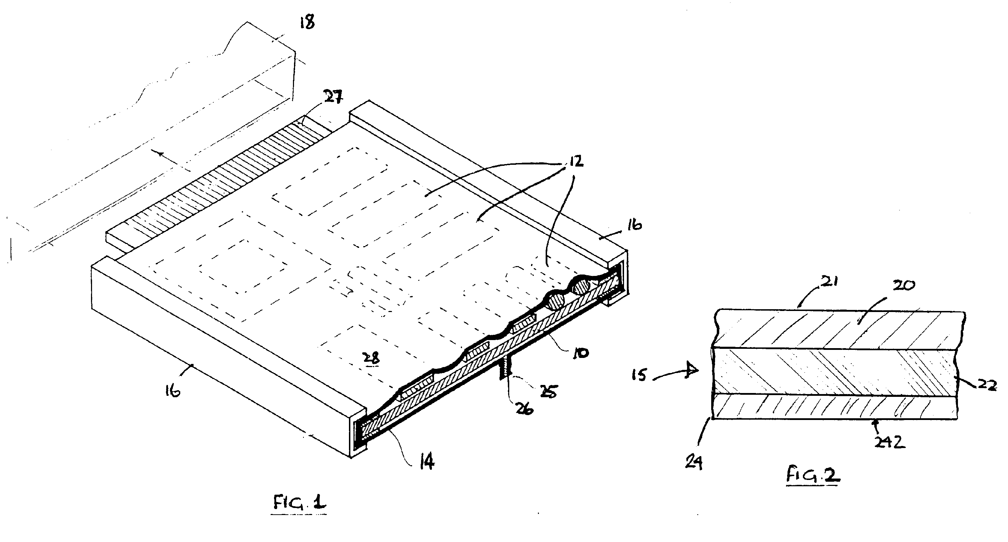

Reference is first made to Fig. 1 of the drawings which depicts a printed circuit board 10 having a plurality of components 12 disposed thereon covered with a circuit protection device in the form of a flexible bag 14 and disposed in card guides 16 for sliding into an enclosure 18 as is typical in the art. The circuit protection device 14 is, in one embodiment of the invention, in the form of a three layered laminate 15, as best seen in Fig 2, which has been evacuated and sealed onto the printed circuit board 10 so that an inner surface 242 of the laminate contacts the tops of components 12 as seen in Fig. 1. The detailed construction of the laminate and its function in providing electromagnetic shielding and thermal management will be later described in detail.

The structure of one embodiment of the laminate of the invention is depicted in Fig. 2. The laminate has three layers bonded together: a first outer layer of an electrically insulating polymer 20 having a thickness in the range 10 to 40 microns and in the example shown is 25 microns thick; a second electrically conductive core 22 which is 30 microns thick but may be in the range of 15 to 45 microns; and a third thinner electrically insulating polymer 24 preferably of 12 microns thickness but may be in the range of 6 to 18 microns and which is disposed innermost and prevents shorting between the conductors and components on the printed circuit board 10 and the electrically conductive core 22.

The laminate is made in sheet form in accordance with established techniques and for each circuit protection device a single piece of laminate is used to ensure that an equipotential exists across the surface of the container. All joins 25 on each container or bag are overlapped and the joins are sealed using a suitable adhesive such as an electrical insulating or conductive adhesive 26 as shown in Fig. 1.

In order to protect the PCB 10 the laminate is cut and sealed to form a suitable container and the printed circuit board with components is then inserted into a support as shown in Fig. 1. To ensure that contact is achieved between the top of the components and the laminate the bag is evacuated after insertion and the container is sealed to the board so that the effect is similar to that of shrink-wrapping, the laminate being sufficiently thin to flex between the components as shown in Fig. 1 and ensure good contact. Adhesive gaskets (not shown in the interest of clarity) are used to maintain the vacuum seal around tooling holes and to ensure a smooth edge where the board runs in card guides.

The top layer of electrically insulating polymer is thick enough to prevent inadvertent physical damage to the components and static build-up is prevented as charge is conducted by the electrically conductive core coupled to a ground or earth connection 27 of the printed circuit board so that the conductive layer 22 acts as an efficient zero potential Faraday cage. The earth connection 27 can also be grounded to a corresponding earth terminal on the connector block 18. The grounded conductive core 22 provides electrical interference against electromagnetic radiation and thereby shields the components on the printed circuit board as well as the conductors from picking up signals from such fields in accordance with known electrical principles.

The circuit protection apparatus also provides a thermal management function in addition to that of electromagnetic radiation shielding because the laminate and in particular the electrically conductive layer 22 has a high thermal conductivity and removes heat by conduction from the components 12 on the printed circuit board 10 with which the laminate 14 is in contact. The inner, third electrically insulating layer 24 does not significantly effect the thermal transmission from the components to the thermally conductive core 22. Accordingly, heat generated by components passes through the third layer 24 into the second, electrically conductive layer 22. In a preferred form of the invention a heat absorption layer is provided between the third layer 24 and the second layer 22 to prevent reflection of heat which has been transmitted through the third layer 24 back into the third layer 24. Rather, heat radiated from the components is absorbed by the heat absorption layer and transferred into the second layer 22. Provision of a heat absorption layer ensures efficient thermal management of the circuit protection apparatus and acts to mitigate heat reflection which would occur due to the metallised content of the second, electrically conductive layer. Heat is then transferred through the second layer 22 to the first layer 20.

Thereafter, thermal management is achieved by heat being conducted through the first layer 20 of the laminate to its outer surface 21 where conventional convection cooling can be achieved or the outer surface of the laminate can be coupled to a cold wall so that heat can be removed by thermal conduction. The thermally conductive layer 22 present throughout the laminate increases the area of convection making the efficiency of cooling the components high.

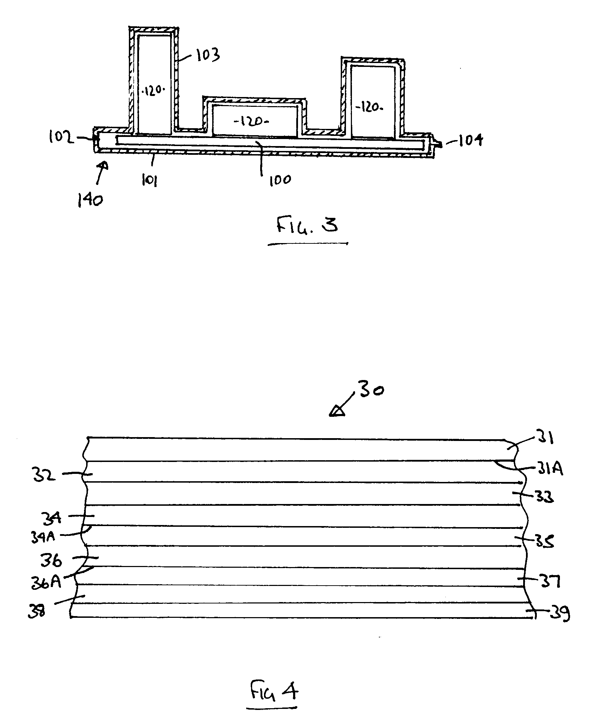

Referring now to Fig. 3 there is illustrated a further embodiment in which the laminate is vacuum formed to conform to the shape of the actual components 120 of the circuit board 100. It will be seen that in the embodiment of Fig. 3 the components 120 are not generally flush with the printed circuit board, as illustrated in Fig. 1, but rather are of substantial height. In order to ensure sufficient contact area between the components 120 and the inner surface of the protective laminate 140 it is in some cases preferable that the laminate is vacuum formed into a rigid shape which is then fitted to the printed circuit board 100. The vacuum formed container has a base 101 which is generally flat but may also be profiled if the under-side of the circuit board 100 has components mounted thereon. To the base 101 there is hinged at 102 a top cover 103 which is shaped to conform to the profile of the components 120 mounted on the circuit board 100. In use the circuit board 100 is placed on the base 101 and the top cover 103 is then folded over and sealed at 104. It will be seen that the shaped top cover 103 closely embraces and contacts the components 120 thus ensuring adequate thermal transfer. It will be appreciated that in this design the step of evacuation may not be required. In the embodiment of Fig. 3 the electrically conductive layer of the laminate 140 can conveniently be made of a deformable, metallic, generally woven surface tissue held in a resin base to allow moulding into the desired shape without loss of conductivity.

It will be appreciated that various modifications may be made to the laminate and container hereinbefore described without departing from the scope of the invention. For example, a hydrophilic coating may be disposed on the inner surface of the third layer to absorb residual moisture which may be present after vacuum sealing has occurred so that if the dew point falls moisture does not condense onto the circuit. Furthermore, an anti-static coating may be disposed on the bottom surface of the inner electrical insulating layer to prevent rubbing of the bottom insulating layer generating the static. The anti-static coating can be used with or without the hydrophilic coating. The multi-layered electrically conductive layer 22 can be used to provide specific screening properties and may be composed of different materials such as copper, gold or nickel such that electromagnetic shielding can be optimised to shield signals of specific frequencies. The multi-layered core may be made electrically conductive using vacuum sputtering or other vacuum metalising techniques. The laminate may be made in a single process or by bonding separate sheets with a suitable adhesive.

Referring now to Fig. 4 there is illustrated, in exploded cross section, an embodiment of a laminate forming the present invention which includes a number of preferred layers. The laminate 30 shown in Fig. 4 is made up of the following layers. A first insulation layer 31 is the outer layer giving insulated protection against the exposed conductors within the enclosure of the electrical apparatus. The layer 31 may be printed with an identification or security code on its lower surface 31A. A thermochromic layer 32 which serves to provide an indication of overheating components for fault finding. A bonding layer 33 adapted to bond the insulation layer 32 to a conductive layer 34. The conductive layer or core 34 provides electromagnetic interference shielding and has high thermal transfer properties. The lower face 34A of the conductive layer 34 has applied thereto a heat absorption layer 35 which acts to prevent reflection of heat emanating from the components of the circuit board. The heat absorption layer 35 thus absorbs heat from the components and transfers the heat into the conductive layer 34. It is the presence of this heat absorption layer 35 which permits the laminate of the invention to effect thermal management of the covered circuit board. To the heat absorption layer 35 there is bonded a lower insulation layer 36. The layer 36 is electrically insulating to prevent the conductive layer 34 shorting out the components of the circuit board. Also, the layer 36 is thermally stable and conductive to permit transfer of heat from the circuit board to the layer 34 through the heat absorption layer 35.

On the lower surface 36A of the insulation layer 36 there is provided an anti-static layer 37 which serves to prevent triboelectric charging of the laminate caused by friction during insertion or removal of the circuit board. The anti-static layer 37 is also thermally stable and conductive so that heat may be passed to the preceding layers. A hydrophilic layer 38 is provided on the anti-static layer 37 to absorb any moisture which may be retained in the package after sealing. Finally, a bonding layer 39 is applied which can be heat or pressure activated to effect final sealing of the package once the circuit board has been inserted.

The above described laminate is such that it can be formed into a bag or envelope for simple flat circuit boards. The bag may be evacuated to effect vacuum sealing to the board so that the laminate contacts the top surface of the components.

For more complex boards where the components have a relatively high cross section profile the laminate may be vacuum formed into a rigid hinged box into which the circuit board is placed. When the box is closed and sealed the laminate contacts the surface of the components to permit adequate thermal transfer.

The thermal management achieved by the circuit protection laminate can be visually assessed by the layer of thermographic crystals on the top surface of the electrically conducting layer to provide a visual indication of the temperature gradient achieved during operation which permits thermal performance to be readily monitored. The thermographic crystals change colour with temperature providing an indication of hot spots and heat distribution from the core throughout the laminate. Furthermore, the identification layer disposed within the laminate on the top surface is particularly useful for security purposes and the low friction coating disposed on the first outer layer facilitates sliding of the protected PCB within the card guides. Such a friction coating can be TEFLON or TEDLAR (Trade Marks).

Advantages of the present invention are that the laminate is easily made into bags or containers of particular sizes and shapes to suit the various sizes of components and circuit boards and can be used with a variety of different types of circuit boards using conventionally inserted components on printed circuit boards and surface mount technology. The system is particularly useful in providing a thermal management for surface mount boards where conventional conduction cooling techniques cannot be used. The use of a conductive core facilitates efficient electromagnetic shielding of the components and conductors on the printed circuit board, and the selection of various materials on the conductive core allows optimising screening of the circuitry against specific frequencies.

In addition, by fully enclosing the board within a sealed bag or rigid container the circuit is protected against moisture ingress and against dust or debris which might cause a short circuit. This is especially useful with circuitry where closely spaced tracking is employed. Furthermore, the use of a hydrophilic layer on the inner conductive polymer surface minimises the likelihood of internal condensation occurring. The circuit protection device also increases security because the identification layer incorporated into the laminate and sealed on the board within the bag makes it possible to identify if the board has been tampered with or if a non-standard replacement has been installed. It will also be appreciated that the requirement for additional anti-static protection is eliminated both during transit and during assembly and the bag remains on the circuit at all times providing protection and thermal management which has not hitherto been achieved.

## Claims

1. A circuit protection device (14,101,103), comprising a first, electrically insulating layer (20,31); a second, electrically conductive layer (22, 34); and a third, electrically insulating layer (24,36); characterized in that the second layer (22,34) has a high thermal conductivity and in that said layers are arranged to form a deformable laminate.

2. Device as claimed in Claim 1 characterised in that a thermal absorption layer (35) is provided between the second layer (34) and the third layer (36).

3. Device as claimed in Claim 1 characterised in that said first layer (20,31), said second layer (22,34), and said third layer (24,36) are polymers.

4. Device as claimed in Claim 1 characterised in that said second, electrically conductive, layer (22,34) consists of a multi-layered core for providing specific properties for shielding said circuit (10,100) against particular frequencies of electromagnetic radiation.

5. Device as claimed in Claim 1 characterised in that said third electrically insulating layer (36) has a hydrophillic coating (38) on its inner surface.

6. Device as claimed in Claim 1 characterised in that an anti-static coating (37) is provided on the inner surface of the third electrically insulating layer (36).

7. Device as claimed in Claim 1 characterised in that a layer of thermographic crystals (32) is disposed on the surface of the second electrically conductive layer (34) adjacent the first insulating layer (31) for providing a visual indication of temperature.

8. Device as claimed in any one of Claims 1 to 7 characterised in that the laminate is formed into a container (101,103) for receiving a circuit board having a plurality of components to be protected.

9. Device as claimed in Claim 8 characterised in that the container is in the form of a bag made from a single sheet of laminate to ensure that an equipotential exists over the bag and all joins on the bag are overlapped.

10. Device as claimed in Claim 8 characterised in that the container (101,103) is in the form of a rigid vacuum formed box.

11. Use of the device as claimed in Claim 9 characterised in that the bag is fitted over a circuit board assembly and the bag is evacuated so that the inner surface of the laminate (15,30,140) contacts components (120) on the circuit board.

12. A method of protecting an electrical component, with a device as disclosed in Claims 1 to 10 characterised in that there is included the step of shaping the laminate (15,30,140) to be in close contact to the components of the circuit to be protected such that the apparatus protects the circuits both during transit and use of the circuit (10,100).

## Patentansprüche

1. Schutzvorrichtung (14, 101, 103) für eine Schaltung, bestehend aus einer ersten, elektrisch isolierenden Schicht (20, 31); einer zweiten, elektrisch leitfähigen Schicht (22, 34); und einer dritten, elektrisch isolierenden Schicht (24, 36); dadurch gekennzeichnet, daß die zweite Schicht (22, 34) eine hohe thermische Leitfähigkeit hat und daß die Schichten zur Ausbildung eines verformbaren Laminats angeordnet sind.

2. Vorrichtung nach Anspruch 1, dadurch gekennzeichnet, daß eine thermische Absorptionsschicht (35) zwischen der zweiten Schicht (34) und der dritten Schicht (36) vorgesehen ist.

3. Vorrichtung nach Anspruch 1, dadurch gekennzeichnet, daß die erste Schicht (20, 31), die zweite Schicht (22, 34) und die dritte Schicht (24, 36) Polymere sind.

4. Vorrichtung nach Anspruch 1, dadurch gekennzeichnet, daß die zweite, elektrisch leitfähige Schicht (22, 34) aus einem vielschichtigen Kern zur Bereitstellung von spezifischen Eigenschaften für eine Abschirmung der Schaltung (10, 100) gegen besondere Frequenzen der elektromagnetischen Strahlung besteht.

5. Vorrichtung nach Anspruch 1, dadurch gekennzeichnet, daß die dritte, elektrisch isolierende Schicht (36) eine hydrophile Beschichtung (38) an der Innenseite aufweist.

6. Vorrichtung nach Anspruch 1, dadurch gekennzeichnet, daß eine antistatische Beschichtung (37) an der Innenseite der dritten, elektrisch isolierenden Schicht (36) vorgesehen ist.

7. Vorrichtung nach Anspruch 1, dadurch gekennzeichnet, daß eine Schicht thermographischer Kristalle (32) an der Seite der zweiten, elektrisch leitfähigen Schicht (34) neben der ersten isolierenden Schicht (31) angeordnet ist für die Schaffung einer visuellen Temperaturanzeige.

8. Vorrichtung nach einem der Ansprüche 1 bis 7, dadurch gekennzeichnet, daß das Laminat zu einem Behälter (101, 103) für die Aufnahme einer gedruckten Schaltung mit einer Vielzahl zu schützender Komponenten ausgebildet ist.

9. Vorrichtung nach Anspruch 8, dadurch gekennzeichnet, daß der Behälter in der Ausbildung eines Beutels ist, hergestellt aus einer einzigen Lage eines Laminats, um zu versichern, daß ein gleiches Potential bei dem gesamten Beutel vorherrscht und alle Zusammenfügungen an dem Beutel überlappt sind.

10. Vorrichtung nach Anspruch 8, dadurch gekennzeichnet, daß der Behälter (101, 103) in der Ausbildung einer starren, unter Vakuum ausgebildeten Schachtel ist.

11. Verwendung der Vorrichtung nach Anspruch 9, dadurch gekennzeichnet, daß der Beutel über eine gedruckte Schaltungsanordnung gepreßt und der Beutel evakuiert ist, sodaß die Innenseite des Laminats (15, 30, 140) die Komponenten (120) auf der gedruckten Schaltung berührt.

12. Verfahren zum Schutz einer elektrischen Komponente mit einer Vorrichtung gemäß den Ansprüchen 1 bis 10, dadurch gekennzeichnet, daß die Stufe einer Formgebung des Laminats (15, 30, 140) für eine enge Berührung mit den Komponenten der Schaltung für einen solchen Schutz eingeschlossen ist, daß die Vorrichtung die Schaltungen sowohl während der Überführung als auch während des Gebrauchs der Schaltung (10, 100) schützt.

## Revendications

1. Dispositif de protection de circuit (14,101, 103), comprenant une première couche électriquement isolante (20,31) ; une deuxième couche électriquement conductrice (22,34) ; et une troisième couche électriquement isolante (24,36) ; caractérisé en ce que la deuxième couche (22,34) a une conductivité thermique élevée et en ce que lesdites couches sont agencées pour constituer un stratifié déformable.

2. Dispositif suivant la revendication 1, caractérisé en ce qu'une couche d'absorption thermique (35) est prévue entre la deuxième couche (34) et la troisième couche (36).

3. Dispositif suivant la revendication 1, caractérisé en ce que ladite première couche (20,31), la dite deuxième couche (22,34) et ladite troisième couche (24,36) sont des polymères.

4. Dispositif suivant la revendication 1, caractérisé en ce que ladite deuxième couche électriquement conductrice (22,34) consiste en une âme multicouche pour l'obtention de propriétés spécifiques de protection dudit circuit (10,100) contre des fréquences particulières de rayonnement électromagnétique.

5. Dispositif suivant la revendication 1, caractérisé en ce que ladite troisième couche électriquement isolante (36) comporte un revêtement hydrophile (38) sur sa surface intérieure.

6. Dispositif suivant la revendication 1, caractérisé en ce qu'un revêtement antistatique (37) est prévu sur la surface intérieure de la troisième couche électriquement isolante (36).

7. Dispositif suivant la revendication 1, caractérisé en ce qu'une couche de cristaux thermographiques (32) est disposée sur la surface de la deuxième couche électriquement conductrice (34) adjacente à la première couche isolante (31), pour fournir une indication visuelle de température.

8. Dispositif suivant une quelconque des revendications 1 à 7, caractérisé en ce que le stratifié est formé en un récipient (101,103) pour recevoir un panneau de circuit comportant une pluralité de composants à protéger.

9. Dispositif suivant la revendication 8, caractérisé en ce que le récipient est sous la forme d'un sac fabriqué à partir d'une seule feuille de stratifié, afin d'assurer qu'un même potentiel existe dans tout le sac, et toutes les jonctions sur le sac sont à recouvrement.

10. Dispositif suivant la revendication 8, caractérisé en ce que le récipient (101,103) et sous la forme d'une boîte rigide formée sous vide.

11. Utilisation du dispositif suivant la revendication 9, caractérisée en ce que le sac est placé sur un assemblage de panneau de circuit, et le sac est mis sous vide de sorte que la surface intérieure du stratifié (15, 30,140) vienne en contact avec les composants (120) sur le panneau de circuit.

12. Procédé de protection d'un composant électrique au moyen d'un dispositif suivant les revendications 1 à 10, caractérisé en ce qu'il comprend l'étape de mise en forme du stratifié (15,30,140) en contact étroit avec les composants du circuit à protéger, de sorte que l'appareil protège les circuits à la fois pendant le transport et l'utilisation du circuit (10,100).
